# EUROPEAN PATENT APPLICATION

(11) **EP 1 863 095 A2**
(43) Date of publication of application: **05.12.2007**
(21) Application number: 07010697.6
(22) Date of filing: 30.05.2007
(51) Int. Cl.: H01L 27/32

(54) **Thin film transistor array panel and method of manufacturing the same**

(30) Priority: 01.06.2006 KR 20060049323
(71) Applicant: Samsung Electronics Co., Ltd., Yeongtong-gu Suwon-city, Gyeonggi-do 442-742 (KR)
(72) Inventor: Song, Keun-Kyu, Yongin-si, Gyeonggi-do (KR); Kim, Bo-Sung, Seocho-gu, Seoul (KR); Cho, Seung-Hwan, Hwaseong-si, Gyeonggi-do (KR)
(74) Representative: Weitzel, Wolfgang

(57) **Abstract**

A thin film transistor array panel including a substrate, a plurality of data lines disposed on the substrate, an interlayer insulating layer disposed on the data lines and including contact holes through which the data lines are exposed, a plurality of source electrodes, each of the source electrodes disposed on the interlayer insulating layer and connected to the data line through the contact hole, a plurality of pixel electrodes, each of the pixel electrodes disposed on the interlayer insulating layer and including a drain elsetrode that faces a source electrode, organic semiconductors disposed on and partially overlapping the source electrodes and the drain electrodes, a gate insulating layer disposed on the organic semiconductors and gate lines disposed on the gate insulating layer and including gate electrodes overlapping the organic semiconductors.

## Description

This application claims priority to Korean Patent Application No. 10-2006-0049323 filed on June 01, 2006, and the entire contents of which are incorporated herein by reference in its entirety,

### BACKGROUND OF THE INVENTION

### (a) Field of the Invention

The present invention relates to a thin film transistor array panel and a method of manufacturing the same.

### (b) Description of the Related Art

Flat panel displays, such as liquid crystal displays ("LCDs"), organic light emitting diode ("OLED") displays, electrophoretic displays, and the like include multiple pairs of field generating electrodes and electro-optical active layers interposed therebetween. The LCDs include liquid crystal layers as the electro-optical active layers, and the OLED displays include organic light emitting layers as the electro-optical active layers.

One of the pair of field generating electrodes is connected to a switching element and receives an electric signal, The electro-optical active layer converts this electrical signal into an optical signal, thereby displaying images.

The flat panel display uses a thin film transistor ("TFT"), which is a three-terminal element, as a switching element. The flat panel display includes gate lines that transmit scanning signals to control the TFT and data lines that transmit signals to be applied to pixel electrodes.

A semiconductor that forms the TFT is generally formed of silicon. Instead of the silicon, research on organic thin film transistors ("OTFTs") using an organic material has actively been undertaken.

A characteristic of a thin film transistor is affected by a contact characteristic between an organic semiconductor and a gate insulating layer. In a case of a bottom gate, since the contact characteristic between the organic semiconductor and the gate insulating layer varies according to the taper angle of source and drain electrodes, the characteristic of the thin film transistors is not stable.

### BRIEF SUMMARY OF THE INVENTION

An exemplary embodiment provides a thin film transistor array panel and a method of manufacturing the same, having advantages of stably maintaining a contact characteristic between an organic semiconductor and a gate insulating layer without being affected by the taper angle of source and drain electrodes.

An exemplary embodiment provides a thin film transistor array panel that includes a substrate, a plurality of data lines disposed on the substrate, an interlayer insulating layer disposed on the data lines and including contact holes through which the data lines are exposed, a plurality of source electrodes, each of the source electrodes disposed on the interlayer insulating layer and connected to a data line through a contact hole, a plurality of pixel electrodes, each of the pixel electrodes disposed on the interlayer insulating layer and including a drain electrode facing a the source electrode, organic semiconductors disposed on and partially overlapping the source electrodes and the drain electrodes, a gate insulating layer disposed on the organic semiconductors, and gate lines disposed on the gate insulating layer and including gate electrodes overlapping the organic semiconductors.

In an exemplary embodiment, the gate insulating layer and the gate lines may have substantially the same plane pattern.

In an exemplary embodiment, the gate insulating layer may cover a side surface of each of the organic semiconductors,

In an exemplary embodiment, a side of the source electrode and a side of the drain electrode, which face each other, may meander. The organic semiconductors may be disposed between facing source and drain electrodes and may contact the interlayer insulating layer.

In an exemplary embodiment, light blocking members disposed on the substrate and overlapping the organic semiconductors may be further included.

In an exemplary embodiment, storage electrode lines disposed on the same layer as the gate lines may be further included.

An exemplary embodiment provides a method of manufacturing a thin film transistor array panel, the method including forming data lines on a substrate, forming an interlayer insulating layer on the data lines, forming pixel electrodes and source electrodes connected to the data lines on the interlayer insulating layer, forming organic semiconductors on the source electrodes and the pixel electrodes, and forming a gate insulating layer and gate lines on the organic semiconductors. Side surfaces of the pixel electrodes and the source electrodes face each other, The organic semiconductors may be disposed between the facing side surfaces.

In an exemplary embodiment, the forming a gate insulating layer and gate lines may include laminating an insulating layer and a metal layer on the organic semiconductors, and patterning the metal layer and the insulating layer at the same time.

In an exemplary embodiment, the forming organic semiconductors may include using a shadow mask.

In an exemplary embodiment, the forming source electrodes and the pixel electrodes may include forming an ITO layer at room temperature, and performing a photolithographic process on the ITO layer.

An exemplary embodiment provides a thin film transistor array panel that includes a substrate, source electrodes disposed on the substrate, drain electrodes facing the source electrodes, semiconductors disposed on and facing the source electrodes and the drain electrodes, a gate insulating layer disposed on the semiconductor, and gate lines disposed on the gate insulating layer and including gate electrodes overlapping the semiconductors. The gate insulating layer and the gate lines may have substantially the same plane pattern,

In an exemplary embodiment, the semiconductors may be disposed between facing drain and source electrodes. The thin film transistor array panel may further include an interlayer insulating layer disposed under the drain and source electrodes where the semiconductors contact the interlayer insulating layer.

In an exemplary embodiment, the semiconductors may be organic semiconductors.

In an exemplary embodiment, the source electrodes may be electrically connected to the data lines.

In an exemplary embodiment, the source electrodes and the drain electrodes may be transparent conductive layers.

### BRIEF DESCRIPTION OF THE DRAWINGS

FIG. 1 is a layout view of an exemplary embodiment of a thin film transistor array panel according to the present invention.

FIG. 2 is a cross-sectional view of the thin film transistor array panel taken along line II-II of FIG. 1.

FIGS. 3, 5, and 7 are layout views illustrating intermediate steps of an exemplary embodiment of a method of manufacturing a thin film transistor array panel according to the present invention.

FIG. 4 is a cross-sectional view of an exemplary embodiment of the thin film transistor array panel taken along line IV-IV of FIG. 3.

FIG. 6 is a cross-sectional view of an exemplary embodiment of the thin film transistor array panel taken along line VI-VI of FIG. 5.

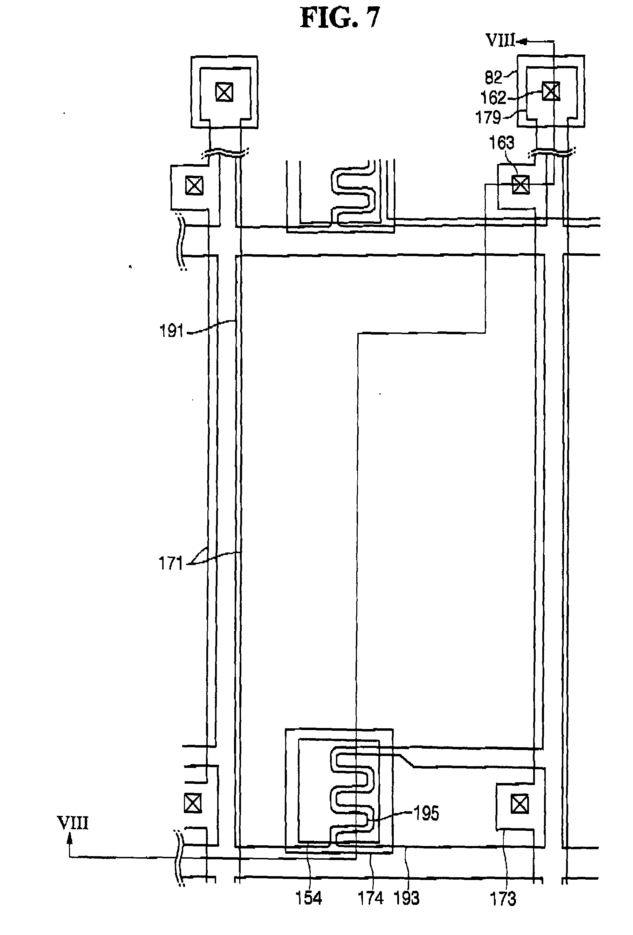

FIG, 8 is a cross-sectional view of an exemplary embodiment of the thin film transistor array panel taken along line VIII-VIII of FIG. 7.

### DETAILED DESCRIPTION OF THE INVENTION

The present invention will be described more fully hereinafter with reference to the accompanying drawings, in which preferred embodiments of the invention are shown. As those skilled in the art would realize, the described embodiments may be modified in various different ways, all without departing from the spirit or scope of the present invention.

In the drawings, the thickness of layers, films, panels, regions, etc., are exaggerated for clarity. Like reference numerals designate like elements throughout the specification. It will be understood that when an element such as a layer, film, region, or substrate is referred to as being "on" or "connected to" another element, it can be directly on or connected to the other element or intervening elements may also be present. In contrast, when an element is referred to as being "directly on' another element, there are no intervening elements present. Like numbers refer to like elements throughout. As used herein, the term "and/or" includes any and all combinations of one or more of the associated listed items.

Spatially relative terms, such as "below", "under," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "below" or "under" relative to other elements or features would then be oriented "above" relative to the other elements or features. Thus, the exemplary term "below" can encompass both an orientation of above and below. The device may be otherwise oriented (rotated 90 degrees or at other orientations) and the spatially relative descriptors used herein interpreted accordingly,

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, Integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated. In the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein,

All methods described herein can be performed In a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the present invention will be described in detail with reference to the accompanying drawings.

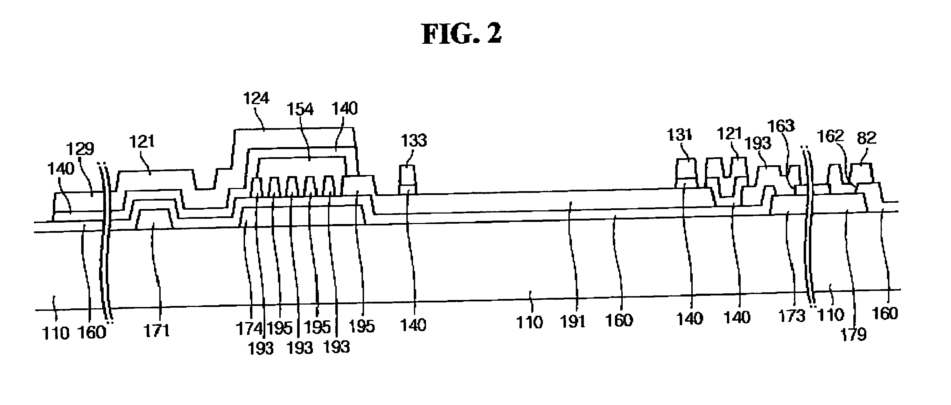

An exemplary embodiment of a thin film transistor array panel according to the present invention will be described in detail with reference to FIGS, 1 and FIG. 2.

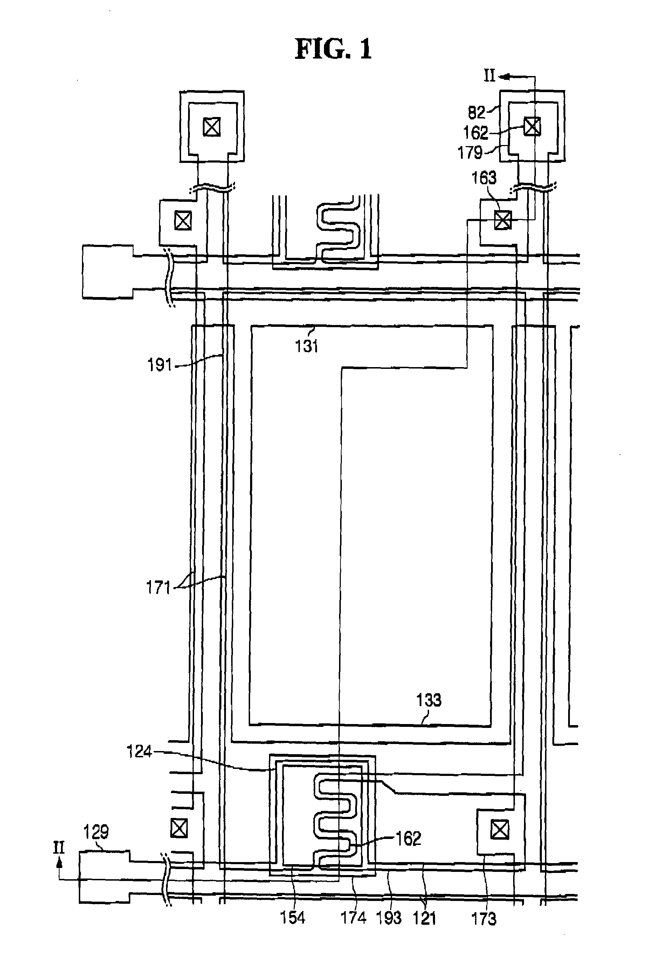

FIG. 1 is a layout view of an exemplary embodiment a thin film transistor array panel according to the present invention, and FIG, 2 is a cross-sectional view of the thin film transistor array panel taken along line II-II of FIG. 1.

A plurality of data conductors that include a plurality of data lines 171 and a plurality of light blocking members 174 are formed on an insulation substrate 110. The insulating substrate 110 may be formed of transparent glass, silicone, or plastic.

The data lines 171 transmit data signals and substantially extend in a vertical (e.g., longitudinal as illustrated in FIG. 1) direction. Each of the data lines 171 includes a plurality of projections 173 that laterally (e.g., transversely as illustrated in FIG. 1) protrude from the data lines 171 and a wide end portion 179 configured to be connected to another layer or an external driving circuit. In an exemplary embodiment, a data driving circuit (not shown) that generates data signals may be mounted on a flexible printed circuit film (not shown) that is attached to the substrate 110, may be directly mounted on the substrate 110, or may be integrated on the substrate 110. When the data driving circuit is integrated on the substrate 110, the data lines 171 may extend and be directly connected to the data driving circuit,

The light blocking members 174 are separated from the data lines 171.

The data conductors 171 and 174 may be formed of a low-resistance conductor. In one exemplary embodiment, the low-resistance conductor may include, but is not limited to, an aluminum-based metal such as aluminum (Al) or an aluminum alloy, a silver-based metal such as silver (Ag) or a silver alloy, a gold-based metal such as gold (Ag) or a gold alloy, a copper-based metal such as copper (Cu) or a copper alloy, a molybdenum-based metal such as molybdenum (Mo) or a molybdenum alloy, chromium (Cr), tantalum (Ta), or titanium (Ti), Alternatively, the data conductors 171 and 174 may have a multilayer structure including two conductive layers (not shown) having different physical properties.

As in the illustrated embodiment, a side surface of each of the data conductors 171 and 174 may be inclined by an angle in the range of about 30 to about 80 degrees with respect to a surface (e.g., an upper substantially planar surface) of the substrate 110.

An interlayer insulating layer 160 is formed on the data conductors 171 and 174. The interlayer insulating layer 160 may include an inorganic insulating material or an organic insulating material. In one exemplary embodiment, the inorganic insulating material may be silicon nitride (SiNₓ) or silicon oxide (SiO₂). The organic insulating material may be polyacryl, polyimide, or benzocyclobutyne (C₁₀H₈), which has excellent durability. Alternatively, the interlayer insulating layer 160 may have a dual-layer structure including both the inorganic insulating material and the organic insulating material,

A plurality of contact holes 162 through which the end portions 179 of the data lines 171 are exposed and a plurality of contact holes 163 through which the projections 173 of the data lines 171 are exposed are formed in the interlayer insulating layer 160.

A plurality of source electrodes 183, a plurality of pixel electrodes 191, and a plurality of contact assistants 82 are formed on the interlayer insulating layer 160. in an exemplary embodiment, the source electrodes 193. the pixel electrodes 191, and the contact assistants 82 may be formed of ITO (indium tin oxide) or IZO (indium zinc oxide).

Each source electrode 193 partially overlaps the light blocking member 174, and is connected to a data line 171 through a contact hole 163.

The pixel electrode 191 partially overlaps the light blocking member 174. The pixel electrode 191 includes a portion 195 (hereinafter, referred to as a "drain electrode") that alternates and faces the source electrode 193. A side of the source electrode 193 and a side of the drain electrode 195 which face each other, are disposed at constant intervals and meander (e.g., a winding path or course as illustrated in the plan view of FIG. 1). As a result, a width of channels, such as of a thin film transistor, can be extended. Each pixel electrode 191 overlaps a gate line 121 and/or a data line 171 so as to increase the aperture ratio.

The contact assistant 82 is connected to the end portion 179 of the data line 171 through the contact hole 162. The contact assistant 82 improves adhesion between the end portion 179 of the data line 171 and an external device (not shown), such as a driver IC, and protects them.

A plurality of organic semiconductor islands 154 are formed on the source electrodes 193 and the drain electrodes 195. As in the illustrated embodiment, a boundary line of the organic semiconductor 154 is disposed inside a boundary line (e.g., outer edges) of the light blocking member 174. The light blocking member 174 overlaps an entire width of the semiconductor island 154, where the width is taken in a direction left to right as illustrated in FIG. 2.

In an exemplary embodiment, the organic semiconductor 154 may include an insoluble low-molecular compound and/or may be formed by vacuum evaporation using a shadow mask. Alternatively, the organic semiconductor 154 may include a high-molecular compound or a low-molecular compound that is soluble in an aqueous solution or an organic solvent. In this case, a partition (not shown) that defines the organic semiconductor 154 is provided, and the organic semiconductor 154 may be formed by using an inkjet printing method.

In an exemplary embodiment, the organic semiconductor 154 may be a derivative containing a tetracene substituent or a pentacene substituent, or may be formed of an oligothiophene where 4 or 8 thiophenes are connected at the 2 or 5 position of a thiophene ring.

In an exemplary embodiment, the organic semiconductor 154 may be formed of thienylene, polyvinylene, or thiophene.

A gate insulating layer 140 is formed on the organic semiconductors 154.

The gate insulating layer 140 may include an inorganic insulating material or an organic insulating material, and a surface thereof may be planarized. In one exemplary embodiment, the inorganic insulating material may include, but is not limited to, silicon nitride or silicon oxide. The silicon oxide may be subjected to surface treatment using OTS (octadecyl-trichloro-silane). In one exemplary embodiment, the organic insulating material may include, but is not limited to, parylene, a fluorine-containing hydrocarbon compound, maleimide-styrene, polyvinylphenol ("PVP"), or modified cyanoethyl pullulan ("m-CEP").

A plurality of gate conductors that include a plurality of gate lines 121 and a plurality of storage electrode lines 131 are formed on the gate insulating layer 140.

The gate lines 121 transmit gate signals and substantially extend in a horizontal direction (e,g., a transverse direction as illustrated in FIG, 1) and cross the data lines 171. Each of the gate lines 121 includes a plurality of gate electrodes 124 that protrude upward (e.g., in the longitudinal direction) from the gate line 121 and are disposed on the light blocking members 174. An end portion 129 of each of the gate lines 121 has a width that is extended or increased configured to be connected to an external circuit or another layer. A gate driving circuit (not shown) that generates gate signals may be mounted on a flexible printed circuit film (not shown) that is attached to the substrate 110, may be directly mounted on the substrate 110, or may be integrated on the substrate 110. When the gate driving circuit is integrated on the substrate 110, the gate lines 121 may extend and be directly connected to the gate driving circuit.

The storage electrode lines 131 are supplied with a predetermined voltage, and each of the storage electrode lines 131 is located between two adjacent gate lines 121. Each of the storage electrode lines 131 includes a plurality of storage electrodes 133. Each of the storage electrodes 133 includes two vertical portions (e.g., edges_that are adjacent to the data line 171 and extend substantially parallel with the data line 171, and horizontal portions (e.g., edges) connected to the vertical portions. In exemplary embodiments, the shape and/or disposition of the storage electrode 133 can be modified.

Like the data conductors 171 and 174, the gate conductors 121 and 131 may be formed of a low-resistance conductor.

A side surface of each of the gate conductors 121 and 131 is inclined with respect to the surface (e.g., the upper surface) of the substrate 110. An inclination angle of the side surface of the gate conductors 121 and 131 may be in a range of about 30 to about 80 degrees.

The gate electrode 124, the source electrode 193, and the drain electrode 195 form the thin film transistor ("TFT") together with the organic semiconductor 154. Channels of the thin film transistors are formed on the organic semiconductors 154 that are adjacent to the gate insulating layer 140. As in the illustrated embodiment, the organic semiconductors 154 are formed on the source electrodes 193 and the drain electrodes 195, and the gate insulating layer 140 is formed on the organic semiconductors 154. Therefore, the channels are stably formed without being affected by the taper (e.g., formed by the inclined side surfaces) of the source electrodes 193 and the drain electrodes 195, Advantageously, a stable thin film transistor is formed without being affected by a contact characteristic between the gate insulating layer 140 and the organic semiconductors 154.

Each pixel electrode 191 is applied with a data voltage from the thin film transistor, and generates an electric field together with a common electrode (not shown) of another display panel (not shown) applied with a common voltage, thereby determining a direction of liquid crystal molecules in a liquid crystal layer (not shown) between the two electrodes. The pixel electrode 191 and the common electrode form a capacitor (hereinafter referred to as a "liquid crystal capacitor), and maintains the applied voltage even after the thin film transistor Is turned off.

The light blocking member 174 is located below the gate electrode 124 and the organic semiconductor 154. Further, the light blocking member 174 blocks incident light and prevents a light leakage current.

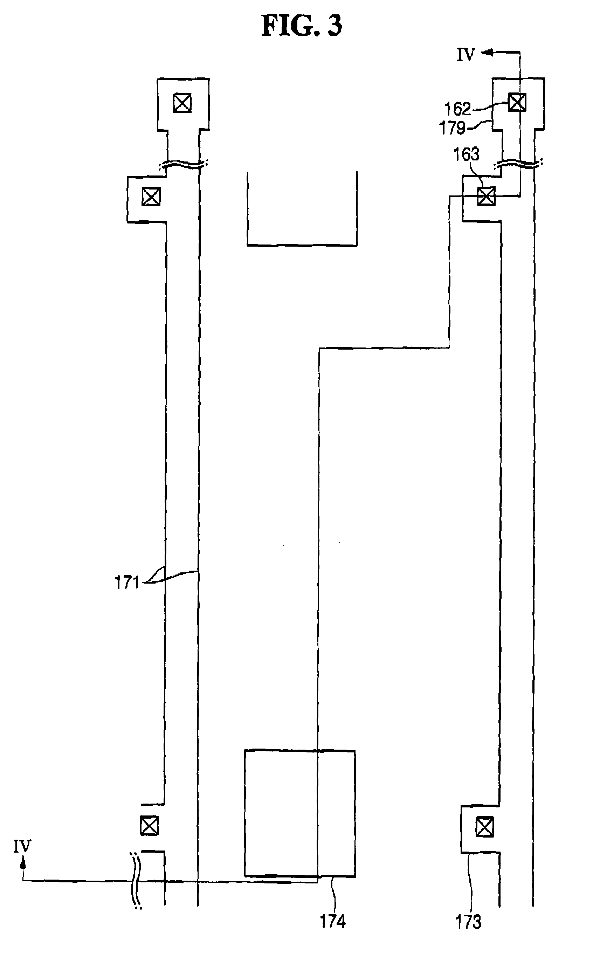

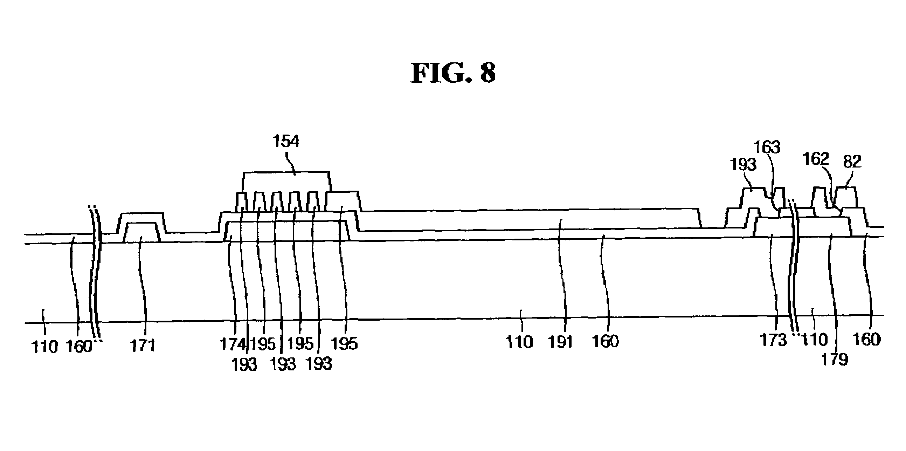

An exemplary embodiment of a method of manufacturing the thin film transistor array panel shown in FIGS. 1 and 2 according to the present invention will now be described in detail with reference to FIGS. 3 to 12.

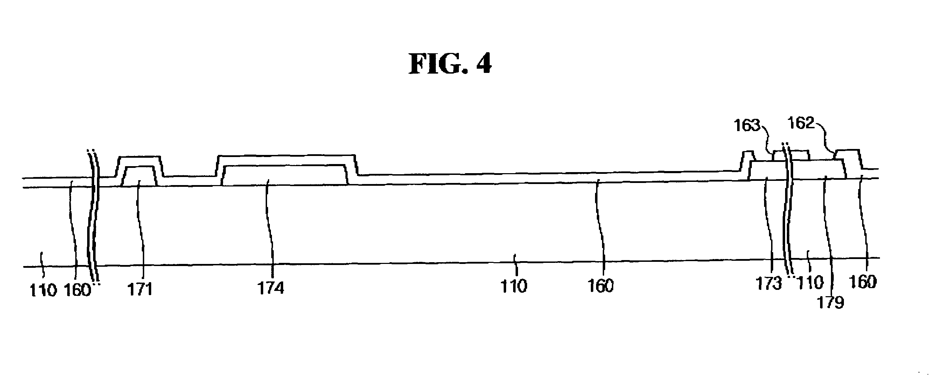

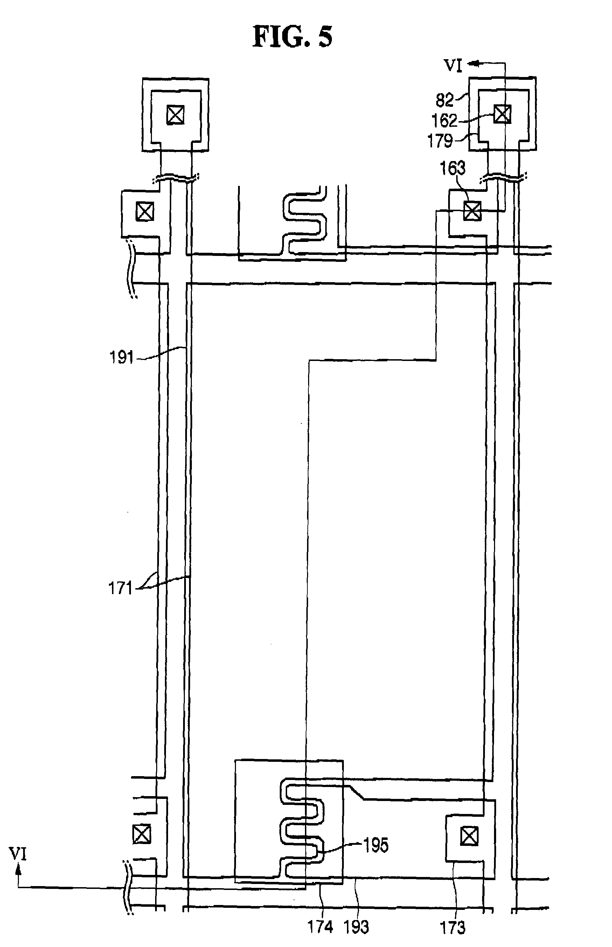

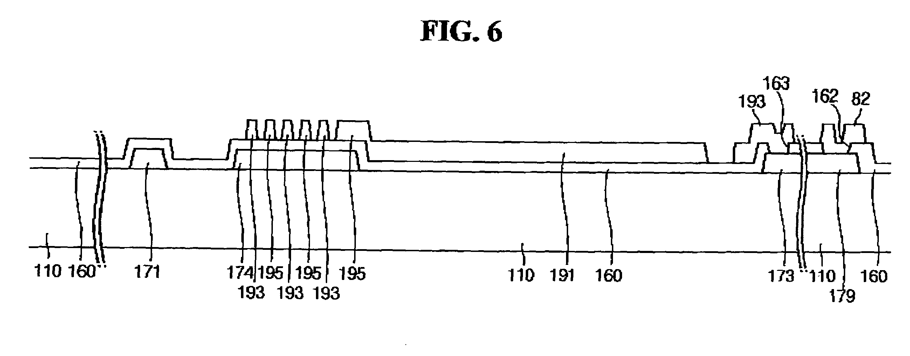

FIGS. 3, 5, and 7 are layout views illustrating intermediate steps of an exemplary embodiment of a method of manufacturing a thin film transistor array panel according to the present invention. FIG. 4 is a cross-sectional view of the thin film transistor array panel taken along line IV-IV of FIG. 3, FIG. 6 is a cross-sectional view of the thin film transistor array panel taken along line VI-VI of FIG. 5, and FIG, 8 is a cross-sectional view of the thin film transistor array panel taken along line Vill-VIII of FIG. 7,

As shown in FIGS. 3 and 4, a metal layer is laminated on an insulation substrate 110, such as by a sputtering process or the like, and a photolithographic process is performed on the metal layer, such that data conductors 171 and 174 are formed.

An interlayer insulating layer 160 including an inorganic material or an organic material is formed on the data conductors 171 and 174. Contact holes 162 and 163 are formed on the interlayer insulating layer 160 by a photolithographic process.

As shown in FIGS, 5 and 6, an amorphous ITO layer is laminated on the interlayer insulating layer 160 and is then subjected to a photolithographic process, such that a plurality of source electrodes 193, a plurality of drain electrodes 195, a plurality of pixel electrodes 191, and a plurality of contact assistants 82 are formed.

In an exemplary embodiment, the amorphous ITO layer may be formed by laminating ITO at a temperature of about 80 degrees or less. In one exemplary embodiment, the amorphous ITO layer may be formed by laminating ITO at room temperature. As an etchant for the amorphous ITO layer, a relatively weak base etchant containing an amine (NH₂) component may be used. Where the relatively weak base etchant containing an amine (NH₂) component is used, it is possible to reduce damage to the interlayer insulating layer 160 formed of the organic material during the manufacturing process. In an exemplary embodiment, an annealing process for changing the amorphous ITO into crystalline ITO may be added.

The source electrode 193 is connected to a projection 173 of the data line 171 through the contact hole 163, and the contact assistant 82 is connected to an end portion 179 of the data line 171 through the contact hole 162.

As shown in FIGS. 7 and. 8, a shadow mask that has openings is disposed on the source electrodes 193, the drain electrodes 195, and the pixel electrodes 191. While the shadow mask is disposed, an organic semiconductor material is deposited, such as by vacuum evaporation, so as to form organic semiconductor islands 154 thereon. However, the invention is not limited thereto. Alternatively, the organic semiconductor islands 154 may be formed using a molecular beam deposition method, a sputtering method, a spin coating method, a contact printing method, an inkjet printing method, or the like.

Referring again to FiGS.1 and, 2, an insulating layer and a metal layer for gates are formed on the semiconductors 154.

The metal layer for gates and the insulating layer are patterned so as to form gate lines 121 and a gate insulating layer 140. In an exemplary embodiment, the gate lines 121 and the gate insulating layer 140 may be patterned at substantially the same time, such that the number of masks can be reduced as compared to when an etching process is performed using respective masks for the gate lines 121 and the gate insulating layers 140. In one exemplary embodiment, the gate insulating layer 140 is patterned such that a side surface of each of the organic semiconductors 154 is not exposed.

In an exemplary embodiment, when the gate lines 121 and the gate insulating layer 140 are patterned at the same time, the gate lines 121 and the gate insulating layer 140 may have substantially the same plane pattern (e.g., profile or contour).

As in the illustrated embodiments, it is possible to form channels without an influence of the taper angle of the source electrodes and the drain electrodes while the processes can be simplified. Advantageously, an electrical characteristic of the thin film transistor can be relatively easily made substantially uniform.

While this invention has been described in connection with what is presently considered to be practical exemplary embodiments, It is to be understood that the invention is not limited to the disclosed embodiments, but, on the contrary, is intended to cover various modifications and equivalent arrangements included within the spirit and scope of the appended claims.

## Claims

1. A thin film transistor array panel comprising:
a substrate;
a plurality of data lines disposed on the substrate;
an interlayer insulating layer disposed on the data lines and including contact holes through which the data lines are exposed;
a plurality of source electrodes, each of the source electrodes disposed on the interlayer insulating layer and connected to one of the data lines through one of the contact holes;
a plurality of pixel electrodes, each of the pixel electrodes disposed on the interlayer insulating layer and including a drain electrode facing a source electrode;
organic semiconductors disposed on and partially overlapping the source electrodes and the drain electrodes;
a gate insulating layer disposed on the organic semiconductors; and
gate lines disposed on the gate insulating layer and including gate electrodes overlapping the organic semiconductors.

2. The thin film transistor array panel of claim 1, wherein the gate insulating layer and the gate lines have substantially the same plane pattern.

3. The thin film transistor array panel of claim 1, wherein the gate insulating layer covers a side surface of each of the organic semiconductors.

4. The thin film transistor array panel of claim 1, wherein a side of the source electrode and a side of the drain electrode, which face each other, meander.

5. The thin film transistor array panel of claim 4, wherein the organic semiconductors are disposed between facing drain electrodes and source electrodes and contact the interlayer insulating layer.

6. The thin film transistor array panel of claim 1, further comprising light blocking members disposed on the substrate and overlapping the organic semiconductors.

7. The thin film transistor array panel of claim 6, wherein a distance between outer boundaries of the organic semiconductors is smaller than a distance between outer boundaries of the light blocking members.

8. The thin film transistor array panel of claim 6, wherein the light blocking members are made of the same material as the data line.

9. The thin film transistor array panel of claim 1, further comprising storage electrode lines disposed on a same layer as the gate lines.

10. A method of manufacturing a thin film transistor array panel, the method comprising:
forming data lines on a substrate,
forming an interlayer insulating layer on the data lines;
forming pixel electrodes and source electrodes connected to the data lines
on the interlayer insulating layer, side surfaces of the pixel electrodes and the source electrodes facing each other;
forming organic semiconductors on the source electrodes and the pixel electrodes, the organic semiconductors being between the side surfaces of the pixel electrodes and the source electrodes facing each other; and
forming a gate insulating layer and gate fines on the organic semiconductors.

11. The method of claim 10, wherein the forming a gate insulating layer and gate lines comprises:
laminating an insulating layer and a metal layer on the organic semiconductors; and
patterning the metal layer and the insulating layer at the same time.

12. The method of claim 10, wherein the forming organic semiconductors includes using a shadow mask.

13. The method of claim 10, wherein the forming source electrodes and pixel electrodes comprises:
forming an ITO layer at room temperature; and
performing a photolithographic process on the ITO layer.

14. A thin film transistor array panel comprising:
a substrate;
source electrodes disposed on the substrate;
drain electrodes facing the source electrodes;
semiconductors disposed on and partially overlapping the source electrodes and the drain electrodes;
a gate insulating layer disposed on the semiconductors; and
gate lines disposed on the gate insulating layer and including gate electrodes overlapping the semiconductors,
wherein the gate insulating layer and the gate lines have substantially the same plane pattern.

15. The thin film transistor array panel of claim 14, wherein the semiconductors are disposed between facing drain electrodes and source electrodes.

16. The thin film transistor array panel of claim 15, further comprising an interlayer insulating layer disposed under the source and drain electrodes, the semiconductors contacting the interlayer insulating layer.

17. The thin film transistor array panel of claim 16, further comprising a data line formed under the interlayer insulating layer and the source electrodes are electrically connected to the data lines,

18. The thin film transistor array panel of claim 14, wherein the semiconductors are organic semiconductors.

19. The thin film transistor array panel of claim 14, wherein the source electrodes and the drain electrodes are transparent conductive layers.
